# EUROPEAN PATENT APPLICATION

(11) **EP 1 953 842 A2**
(43) Date of publication of application: **06.08.2008**
(21) Application number: 07024442.1
(22) Date of filing: 17.12.2007
(51) Int. Cl.: H01L 45/00

(54) **Phase change memory device and method for fabricating the same**

(30) Priority: 25.01.2007 TW 96102808
(71) Applicant: INDUSTRIAL TECHNOLOGY RESEARCH INSTITUTE, Chu-Tung, Hsin-Chu Taiwan (CN); Powerchip Semiconductor Corp., Hsin-Chu, Taiwan (TW); Nanya Technology Corporation, Kueishan, Taoyuan (TW); ProMOS Technologies, Inc., Hsinchu (TW); WINBOND ELECTRONICS CORPORATION, Hsinchu (TW)
(72) Inventor: Hsu, Hong-Hui, Yuanlin Township Changhua County 510 (TW)
(74) Representative: Fuchs

(57) **Abstract**

A phase change memory device and fabrication method thereof is provided. The phase change memory device includes a substrate (300). A metal plug (304) is disposed on the substrate and a phase change material film (306a) is disposed on the metal plug, wherein the metal plug is electrically connected to the phase change material film. A heating electrode (312), preferably ring-shaped, is disposed on the phase change material film, wherein the heating electrode is electrically connected to the phase change material film. A conductive layer (316) is disposed on the heating electrode.

## Description

### BACKGROUND OF THE INVENTION

### Field of the Invention

The invention relates to a phase change memory device and method for fabricating the same, and more particularly to a phase change memory device with relatively smaller contact area and higher device density and a method for fabricating the same.

### Description of the Related Art

Phase change memory (PCM) devices may potentially serve as a stand-alone non-volatile memory for the next generation, with advantages of non-volatility, faster operating speed, simpler fabrication process and compatibility with conventional semiconductor fabrication process. Before PCM devices become a mainstream replacement for flash memory, however, they must first achieve reduced device operating current. Fabrication of non-volatile memory with relatively higher device density using the conventional fabrication process is, thus, a major aim of researchers. US Pat. No. 7,023,009 issued by Ovonyx Corporation discloses a conventional PCM. A contact area between a phase change material and a bottom electrode can serve as a contact area between a width of a cup-shaped heating electrode and the phase change material, thus, device density can be improved.

A PCM device with a smaller contact area and higher device density while not limited by photolithography resolution is thus desirable.

### BRIEF SUMMARY OF INVENTION

A detailed description is given in the following embodiments with reference to the accompanying drawings.

The invention provides a phase change memory device and method for fabricating the same. An exemplary embodiment of a phase change memory device comprises a substrate. A metal plug is disposed on the substrate and a phase change material film on the metal plug, wherein the metal plug is electrically connected to the phase change material film. A heating electrode is disposed on the phase change material film, wherein the heating electrode is electrically connected to the phase change material film. A conductive layer is disposed on the heating electrode.

A method of fabricating a phase change memory device comprises providing a substrate; forming a metal plug and a phase change material film on the substrate in sequence, wherein the metal plug is electrically connected to the phase change material film; forming a heating electrode on the phase change material film, wherein the heating electrode is electrically connected to the phase change material film; forming a conductive layer on the heating electrode.

### BRIEF DESCRIPTION OF DRAWINGS

The invention can be more fully understood by reading the subsequent detailed description and examples with references made to the accompanying drawings, wherein:

FIGS. 1a to 1m are cross sections of a first exemplary embodiment of a phase change memory device.

FIGS. 2a to 2g are cross sections of a second exemplary embodiment of a phase change memory device.

### DETAILED DESCRIPTION OF INVENTION

The following description is of the best-contemplated mode of carrying out the invention. This description is made for the purpose of illustrating the general principles of the invention and should not be taken in a limiting sense. The scope of the invention is best determined by reference to the appended claims.

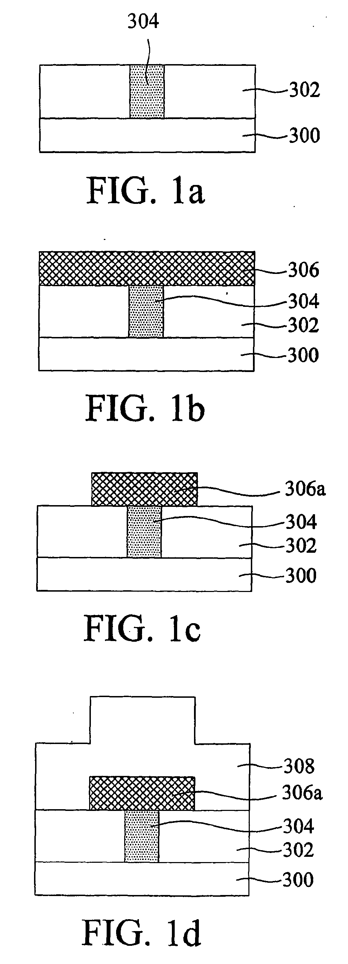

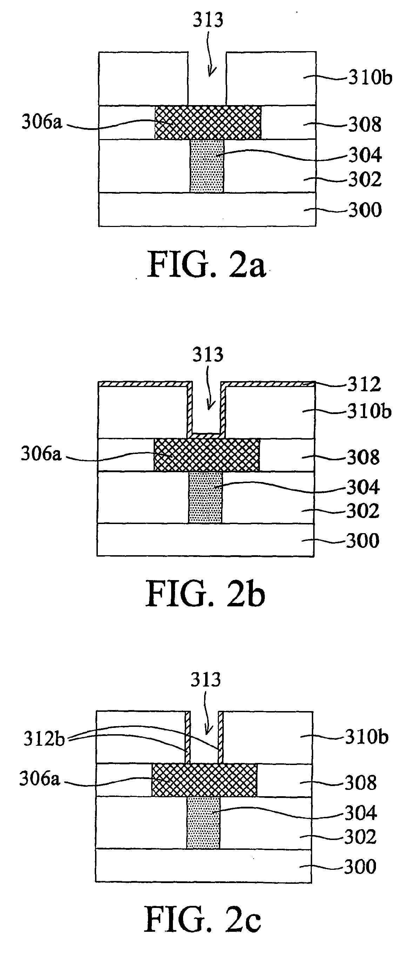

FIGS. 1a to 1m are cross sections of a first exemplary embodiment of a phase change memory device. FIGS. 2a to 2g are cross sections of a second exemplary embodiment of a phase change memory device. Wherever possible, the same reference numbers are used in the drawings and the descriptions of the same or like parts.

FIG. 1a is a cross section of the first exemplary embodiment of the phase change memory device. A substrate 300 is provided. The substrate 300 may comprise silicon, or, in alternative embodiments, SiGe, bulk semiconductor, strained semiconductor, compound semiconductor, silicon on insulator (SOI), and other commonly used semiconductor substrates. In one embodiment, the substrate 300 may be a substrate comprising a transistor such as a complementary metal oxide semiconductor (CMOS) or a bipolar junction transistor (BJT). A dielectric layer 302 is formed on the substrate 300 by a deposition process such as chemical vapor deposition (CVD). The dielectric layer 302 may comprise silicon dioxide (SiO₂), silicon nitride (SiNₓ) or the like. The dielectric layer 302 is then covered with a patterned photoresist layer (not shown) to define the position of a metal plug 304, and subsequent anisotropic etching to remove the dielectric layer 302 not covered by the patterned photoresist layer until the substrate 300 is exposed. Next, the patterned photoresist layer is removed to form an opening. Next, a metal layer (not shown) may be formed on the dielectric layer 302 filling in the opening by physical vapor deposition (PVD), sputtering, low pressure chemical vapor deposition (LPCVD), atomic layer chemical vapor deposition (ALD) or electroless plating. A planarizing process such as chemical mechanical polishing (CMP) may be performed to remove the excess metal layer to form the metal plug 304. The metal plug 304 may comprise tungsten (W).

FIG. 1b illustrates a formation of a phase change material film (PC film) 306. The phase change material film 306 is blanketly deposited over the entire region by physical vapor deposition (PVD), thermal evaporation, pulsed laser deposition or metal organic chemical vapor deposition (MOCVD). The phase change material film 306 may comprise binary, ternary or tetra chalcogenide such as GaSb, GeTe, Ge-Sb-Te (GST) alloy, Ag-In-Sb-Te alloy or combinations thereof.

A diffusion barrier layer (not shown) may be formed optionally on the phase change material film 306. The diffusion barrier layer may comprise metal nitrides, for example, WN, TiN, TaN, TiSiN or TaSiN or the like.

Referring to FIG. 1c, a patterned photoresist layer (not shown) may be formed on the phase change material film 306 and the diffusion barrier layer, and subsequent anisotropic etching removes the phase change material film 306 and the diffusion barrier layer not covered by the patterned photoresist layer. Next, the patterned photoresist layer is removed to form a phase change material film 306a. The phase change material film 306a is electrically connected to the metal plug 304.

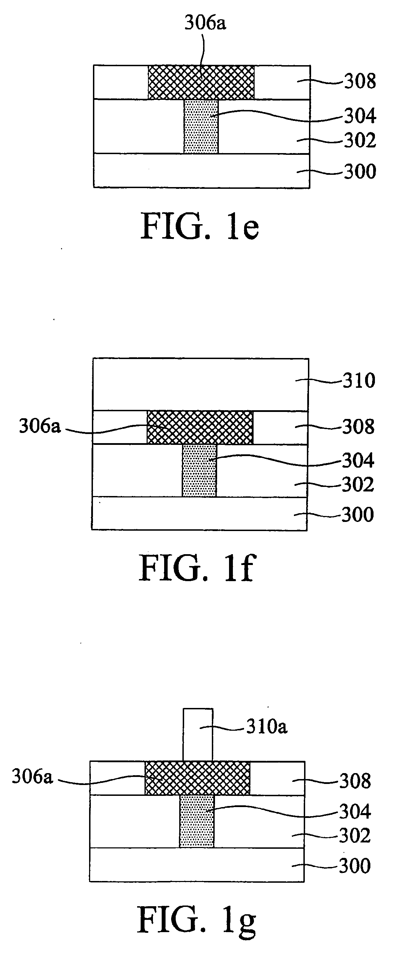

Referring to FIG. 1d, a dielectric layer 308 is blanketly deposited over the entire region by a deposition process such as chemical vapor deposition (CVD). The dielectric layer 308 covers the phase change material film 306a and the dielectric layer 302 not covered by the phase change material film 306a. Next, a planarizing process such as chemical mechanical polishing (CMP) may be performed to remove the excess dielectric layer 308 until the phase change material film 306a is exposed as shown in FIG. 1e.

Referring to FIG. 1f, a dielectric layer 310 is blanketly deposited over the entire region by a deposition process such as chemical vapor deposition (CVD). The dielectric layer 310 covers the phase change material film 306a and the dielectric layer 308.

Referring to FIG. 1g, a patterned photoresist layer (not shown) may be formed on the dielectric layer 310 to define the position of a dielectric layer 310a, and subsequent anisotropic etching to remove the dielectric layer 310 not covered by the patterned photoresist layer until the phase change material film 306a is exposed. Next, the patterned photoresist layer is removed to form the dielectric layer 310a. The dielectric layer 310a is pillared.

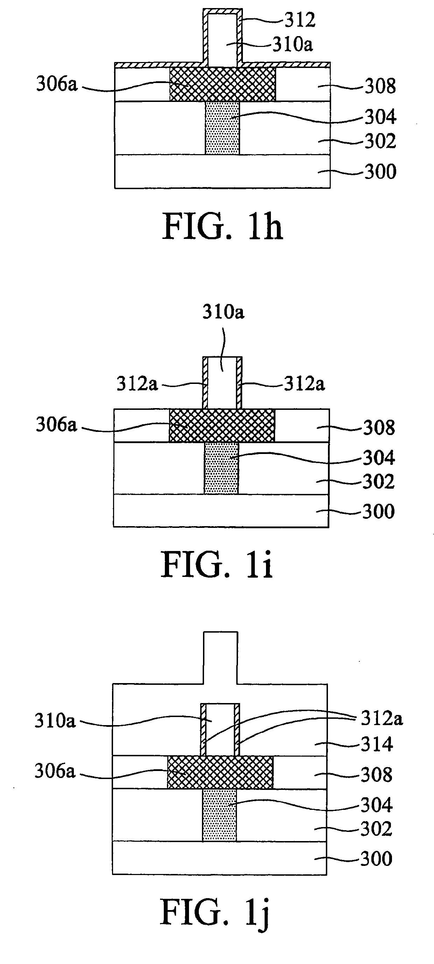

FIG. 1h illustrates a formation of a heating electrode layer 312. The heating electrode layer 312 is conformably deposited over the entire region by physical vapor deposition (PVD), thermal evaporation, pulsed laser deposition or metal organic chemical vapor deposition (MOCVD).

Next, as shown in FIG. 1i, an anisotropic etching is performed to form a heating electrode 312a on a sidewall of the pillared dielectric layer 310a. The resulting heating electrode 312a is ring-shaped. The heating electrode 312a may comprise metal silicides such as Co-salicide (CoSi_{X}), Ta-salicide (TaSi_{X}), Ni-salicide (NiSi_{X}), Ti-salicide (TiSi_{X}), W-salicide (WSi_{X}) or other refractory metal silicides. The heating electrode 312a may also comprise CoSi_{X}N_{Y}, TaSi_{X}N_{Y}, NiSi_{X}N_{Y}, TiSi_{X}N_{Y}, WSi_{X}N_{Y} or other refractory nitride metal silicides. A size of the heating electrode 312a is controlled by the thickness of the heating electrode layer 312. Some fabrication process conditions, for example, deposition time, can be used to properly control the size of the heating electrode 312a. A contact area of the phase change material film 306a and the heating electrode 312a is defined by the size of the heating electrode 312a. The contact area can be reduced by controlling the thickness of the heating electrode layer 312.

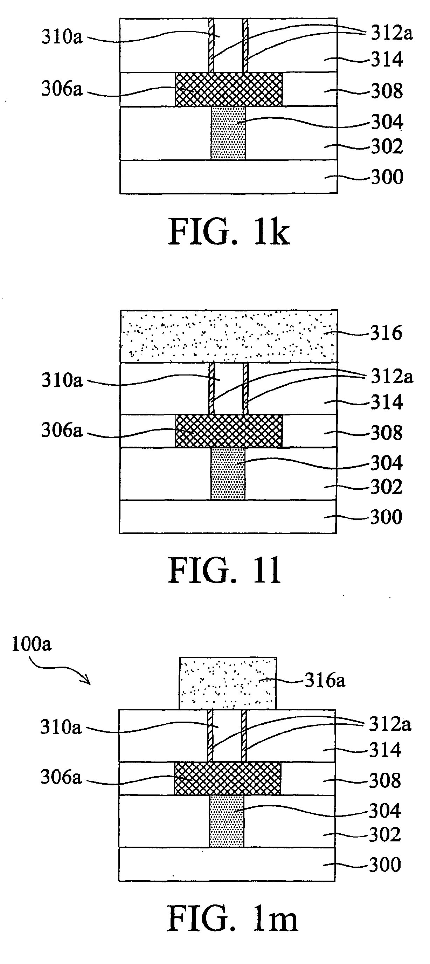

Referring to FIG. 1j, a dielectric layer 314 is blanketly deposited over the substrate 300 by a deposition process such as chemical vapor deposition (CVD), covering the phase change material film 306a, the pillared dielectric layer 310a and the dielectric layer 308. Next, a planarizing process such as chemical mechanical polishing (CMP) may be performed to remove the excess dielectric layer 308 until the heating electrode 312a is exposed as shown in FIG. 1k.

Referring to FIG. 1l, a conductive layer 316 is formed on the dielectric layer 314 covering the heating electrode 312a by physical vapor deposition (PVD), thermal evaporation, pulsed laser deposition or metal organic chemical vapor deposition (MOCVD).

Referring to FIG. 1m, a patterned photoresist layer (not shown) may be formed on the conductive layer 316, and subsequent anisotropic etching to remove the conductive layer 316 not covered by the patterned photoresist layer. Next, the patterned photoresist layer is removed to form a conductive layer 316a. The conductive layer 316a may comprise W, Ti, Al, Al-alloy, Cu, Cu-alloy or combinations thereof. The first exemplary embodiment of the phase change memory device 100a is thus completely formed.

The first exemplary embodiment of a phase change memory device 100a mainly comprises: a substrate 300; a metal plug 304 on the substrate 300and a phase change material film (PC film) 306a on the metal plug 304, wherein the metal plug 304 is electrically connected to the phase change material film (PC film) 306a; a heating electrode 312a on the phase change material film (PC film) 306a covering a sidewall of a pillared dielectric layer 310a on the phase change material film 306a, wherein the heating electrode 312a is ring-shaped; a conductive layer 316a on the heating electrode 312a.

FIGS. 2a to 2g are cross sections of a second exemplary embodiment of a phase change memory device. Fabrication processes of this embodiment are the same as those previously described with reference FIGS. 1a to 1 m, thus descriptions thereof are not repeated for brevity.

FIG. 2a illustrates a formation of a dielectric layer 310b. A patterned photoresist layer (not shown) may be formed on the dielectric layer 310 to define the position of an opening 313, and subsequent anisotropic etching removes the dielectric layer 310 not covered by the patterned photoresist layer until the phase change material film 306a is exposed. Next, the patterned photoresist layer is removed to form the dielectric layer 310b and the opening 313.

FIG. 2b illustrates a formation of a heating electrode layer 312. The heating electrode layer 312 is conformably formed on the dielectric layer 310b, a sidewall and a bottom of the opening 313 by physical vapor deposition (PVD), thermal evaporation, pulsed laser deposition or metal organic chemical vapor deposition (MOCVD).

Next, as shown in FIG. 2c, an anisotropic etching is performed to form a heating electrode 312b on the sidewall of the opening 313. The resulting heating electrode 312b is ring-shaped. The heating electrode 312b may comprise metal silicides such as Co-salicide (CoSi_{X}), Ta-salicide (TaSi_{X}), Ni-salicide (NiSi_{X}), Ti-salicide (TiSi_{X}), W-salicide (WSix) or other refractory metal silicides. The heating electrode 312b may also comprise CoSi_{X}N_{Y}, TaSi_{X}N_{Y}, NiSi_{X}N_{Y}, TiSi_{X}N_{Y}, WSi_{X}N_{Y} or other refractory nitride metal silicides. A size of the heating electrode 312b is controlled by the thickness of the heating electrode layer 312. Some fabrication process conditions, for example, deposition time, can be used to properly control the size of the heating electrode 312b. A contact area of the phase change material film 306a and the heating electrode 312b is defined by the size of the heating electrode 312b. The contact area can be reduced by controlling the thickness of the heating electrode layer 312.

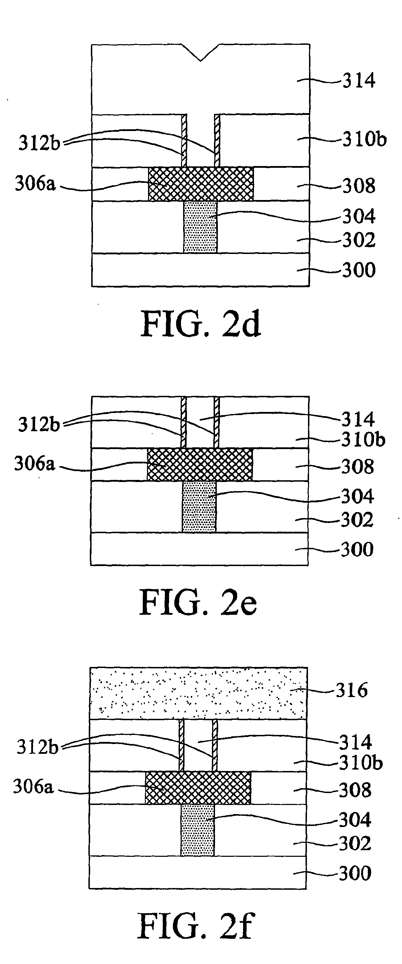

Referring to FIG. 2d, a dielectric layer 314 is blanketly deposited over the substrate 300 by a deposition process such as chemical vapor deposition (CVD), covering the phase change material film 306a and the dielectric layer 310b. The dielectric layer 314 is formed filling in the opening 313 surrounded by the heating electrode 312b as shown in FIG. 2c, covering the heating electrode 312b. Next, a planarizing process such as chemical mechanical polishing (CMP) may be performed to remove the excess dielectric layer 314 until the heating electrode 312b is exposed as shown in FIG. 2e.

Referring to FIG. 2f, a conductive layer 316 is formed on the dielectric layer 314 covering the heating electrode 312b by physical vapor deposition (PVD), thermal evaporation, pulsed laser deposition or metal organic chemical vapor deposition (MOCVD).

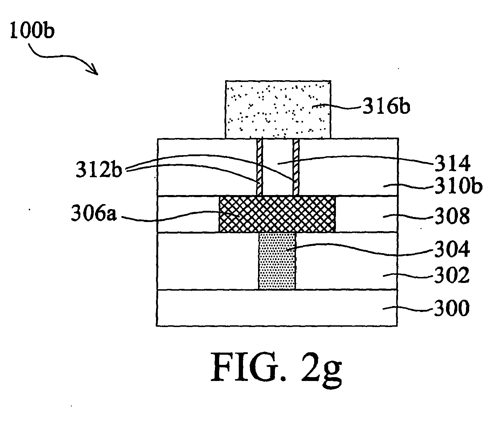

Referring to FIG. 2g, a patterned photoresist layer (not shown) may be formed on the conductive layer 316, and subsequent anisotropic etching removes the conductive layer 316 not covered by the patterned photoresist layer. Next, the patterned photoresist layer is removed to form a conductive layer 316b. The conductive layer 316b may comprise W, Ti, Al, Al-alloy, Cu, Cu-alloy or combinations thereof. The second exemplary embodiment of the phase change memory device 100b is thus completely formed.

The second exemplary embodiment of a phase change memory device 100b mainly comprises: a substrate 300; a metal plug 304 and a phase change material film (PC film) 306a formed on the substrate 300 in sequence, wherein the metal plug 304 is electrically connected to the phase change material film (PC film) 306a; a heating electrode 312b formed on the phase change material film (PC film) 306a covering a sidewall of a dielectric layer 310b, wherein the heating electrode 312b is ring-shaped; a dielectric layer 314 filled in the heating electrode 312b covering a sidewall of the heating electrode 312b; a conductive layer 316a formed on the heating electrode 312b.

In an exemplary embodiment of a phase change memory device, a phase change material film is defined firstly, and a ring-shaped heating electrode is formed thereon. The ring-shaped heating electrode thus contacts the underlying phase change material film. A contact area of the phase change material film and the ring-shaped heating electrode are defined by the size of the ring-shaped heating electrode, not limited by the conventional photolithography resolution. A higher device density can be achieved.

While the invention has been described by way of example and in terms of preferred embodiment, it is to be understood that the invention is not limited thereto. To the contrary, it is intended to cover various modifications and similar arrangements (as would be apparent to those skilled in the art). Therefore, the scope of the appended claims should be accorded the broadest interpretation so as to encompass all such modifications and similar arrangements.

## Claims

1. A phase change memory device, comprising:
a substrate;
a metal plug on the substrate and a phase change material film on the metal plug, wherein the metal plug is electrically connected to the phase change material film;
a heating electrode on the phase change material film, wherein the heating electrode is electrically connected to the phase change material film; and
a conductive layer on the heating electrode.

2. The phase change memory device as claimed in claim 1, wherein the heating electrode is ring-shaped.

3. The phase change memory device as claimed in claim 1, further comprising a pillared dielectric layer on the phase change material film, wherein the heating electrode is formed on a sidewall of the pillared dielectric layer.

4. The phase change memory device as claimed in claim 1, further comprising a dielectric material filled in an opening surrounded by the heating electrode.

5. The phase change memory device as claimed in claim 1, wherein the phase change material film comprises GaSb, GeTe, Ge-Sb-Te alloy, Ag-In-Sb-Te alloy or combinations thereof.

6. The phase change memory device as claimed in claim 1, wherein the heating electrode comprises metal silicides or nitride metal silicides.

7. The phase change memory device as claimed in claim 1, wherein the refractory metal silicides, refractory metal nitrides, nitride refractory metal silicides.

8. The phase change memory device as claimed in claim 1, wherein the heating electrode is formed by physical vapor deposition (PVD), thermal evaporation, pulsed laser deposition or metal organic chemical vapor deposition (MOCVD).

9. A method of fabricating a phase change memory device, comprising:
providing a substrate;
forming a metal plug and a phase change material film on the substrate in sequence, wherein the metal plug is electrically connected to the phase change material film;
forming a heating electrode on the phase change material film, wherein the heating electrode is electrically connected to the phase change material film; and
forming a conductive layer on the heating electrode.

10. The method of fabricating the phase change memory device as claimed in claim 9, wherein the heating electrode is ring-shaped.

11. The method of fabricating the phase change memory device as claimed in claim 9, further comprising:
forming a first dielectric layer on the phase change material film, wherein the first dielectric layer is pillared;
conformably depositing a heating electrode layer on the phase change material film and the first dielectric layer; and
forming a heating electrode on a sidewall of the first dielectric layer by anisotropic etching of the heating electrode layer.

12. The method of fabricating the phase change memory device as claimed in claim 11, further comprising:
blanketly forming a second dielectric layer over the subsrate; and
performing a planarization process to remove a portion of the second dielectric layer until the heating electrode is exposed.

13. The method of fabricating the phase change memory device as claimed in claim 9, further comprising:
forming a first dielectric layer on the phase change material film, wherein the first dielectric layer has an opening;
forming a heating electrode on a sidewall of the opening;
forming a second dielectric layer filling in the opening, covering the heating electrode; and
performing a planarization process to remove a portion of the second dielectric layer until the heating electrode is exposed.

14. The method of fabricating the phase change memory device as claimed in claim 9, wherein the heating electrode is formed by physical vapor deposition (PVD), thermal evaporation, pulsed laser deposition or metal organic chemical vapor deposition (MOCVD).
